# EUROPEAN PATENT SPECIFICATION

(11) **EP 0 459 442 B1**
(45) Date of publication and mention of the grant of the patent: **26.03.1997**
(21) Application number: 91108788.0
(22) Date of filing: 29.05.1991
(51) Int. Cl.: H01L 23/64

(54) **Electronic component including a lead frame with built-in capacitor**
Elektronisches Bauteil, das einen Leiterrahmen mit eingebautem Kondensator enthält
Composant électronique incluant un cadre de connecteur avec condensateur incorporé

(30) Priority: 29.05.1990 DE 4017217
(43) Date of publication of application: 04.12.1991
(73) Proprietor: TEXAS INSTRUMENTS DEUTSCHLAND GMBH, 85356 Freising (DE)
(72) Inventor: Kaiser, Ulrich, W-4788 Warstein 2 (DE)
(74) Representative: Schwepfinger, Karl-Heinz, Dipl.-Ing.

(56) References cited:
- EP-A- 0 180 219
- DE-A- 3 626 151
- GB-A- 2 091 035

## Description

The invention relates to an electronic component of the kind as defined in the preamble of claims 1 and 9. It is concerned with an electronic component comprising a semiconductor chip mounted on a lead frame and at least one capacitor electrically connected to the semiconductor chip.

EP-A-301 127 incorporated herein by reference, discloses a transponder arrangement which comprises an interrogation unit and a responder. For one application the responder has very small dimensions because it is intended for implantation in living animals to enable the individual animals to be identified by transmitting an interrogation signal with the interrogation unit, to which the responder then replies with individual response signals by which the animals can be identified.

A particular feature of the responder of the known transponder arrangement is that it does not have its own power source but obtains the energy it requires for transmitting back its response signal from the interrogation pulse which has been transmitted by the interrogation unit. For this purpose, in the responder the interrogation pulse received by means of a resonance circuit is rectified and the energy contained in the interrogation pulse stored in a capacitor which then represents the energy source for sending back the response signal. Since the responder has very small dimensions, the relatively large capacitor serving for the energy storage and the semiconductor chip containing the electronic circuit of the responder must be accommodated in very restricted space. In the known responder the semiconductor chip is mounted on a lead frame. This constructional unit of semiconductor chip and lead frame is embedded in a plastic composition which serves as housing out of which the necessary leads project. The capacitor serving for the energy storage is soldered directly to said leads. In the same manner, the resonance circuit consisting of a coil and a capacitor is soldered directly to the leads. Because of the small dimensions, attaching these circuit elements to the leads is difficult and can lead to errors (solder bridges and the like).

GB-A-2 091 035 discloses an electronic component comprising a lead frame, a capacitor and a semiconductor chip. The capacitor mounted on the lead frame provides a mounting platform for the semiconductor chip seated on an epoxy or like adhesive layer mounted atop the upper surface of the capacitor. Terminal ends of the lead frame are connected to power terminals of the semiconductor chip by leads. Terminal portions of the lead frame are electrically connected to end terminations of the capacitor, whereby the capacitor is disposed in bridging relation of the power supply terminals of the semiconductor chip.

The invention is based on the problem of providing such an electronic component which can be made with very small dimensions without impairing its functionability on assembly.

The invention as defined in the claims provides a structure in which a flat capacitor having an overall height small in comparison with its peripheral length has contact areas on its exposed flat faces. The capacitor is mounted on a lead frame with the contact area on one face in electrically conductive connection with one or more electrical conductors of the lead frame. The semiconductor chip, for example an integrated circuit chip, is disposed on and adherently attached to the other, opposed face of the capacitor such that the perimeter of the semiconductor chip is substantially accommodated within (i.e., does not significantly project beyond) the perimeter of the capacitor.

In an alternative arrangement, two or more semiconductor chips may be mounted on and adherently attached to said other opposed face of the capacitor and accommodated within the perimeter of the capacitor. In another arrangement, one or more semiconductor chips could be mounted on and adherently attached to two or more flat capacitors (disposed laterally with respect to each other) mounted on and in electrically conductive connection with conductors of the lead frame. In either case, the semiconductor chip(s) is or are accommodated substantially within the overall perimeter occupied by the capacitor(s).

In a particular embodiment of the invention a capacitor formed in particular manner is arranged directly on the lead frame and one or more semiconductor chips are in turn arranged directly on the capacitor. Suitably, the capacitor and semiconductor chip may both be rectangular with the latter having length and width dimensions not greater than those of the capacitor and arranged so that the perimeter of the semiconductor chip does not extend beyond the perimeter of the capacitor. With this construction, no problems are encountered in establishing electrical connections between the lead frame and the one contact area of the capacitor on the one hand and between the other contact area of the capacitor and the semiconductor chip on the other hand. The steps necessary for the assembly can be carried out in simple manner and give moreover a very stable structure.

The semiconductor chip(s) may be adherently attached to the flat capacitor(s) by an electrically conductive adhesive to provide an electrical connection between the chip(s) and the capacitor(s). If such electrical connection is not required, an electrically insulating adhesive may be used instead.

The invention will now be explained with reference to the drawings in which,
Fig. 1 shows a side view of an embodiment of an electronic component according to the invention;
Fig. 2 is an isometric view of the component shown in Fig. 1 ; and
Fig. 3 shows another embodiment of an electronic component according to the invention.

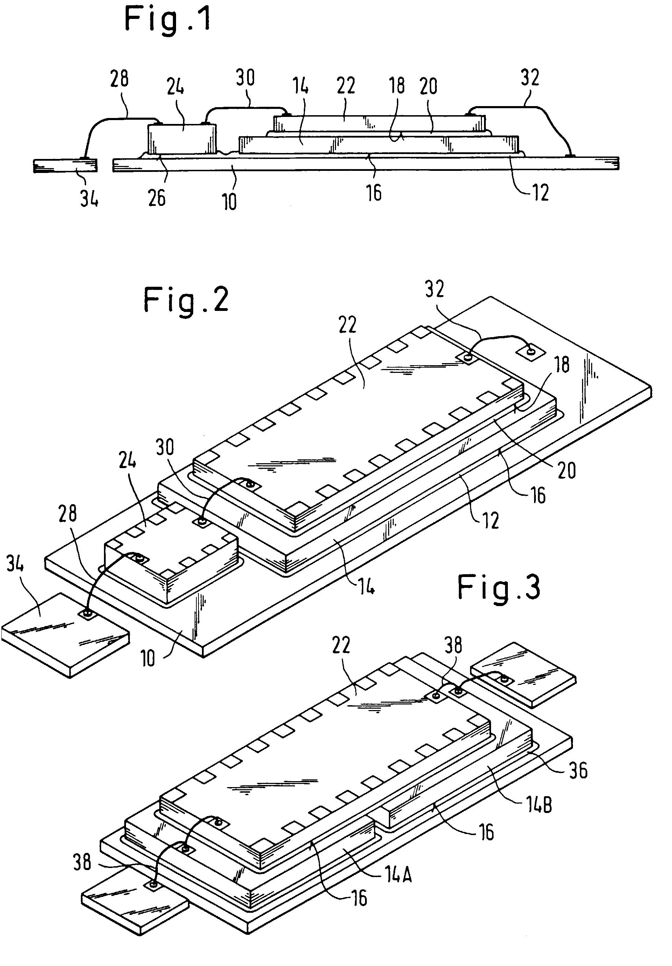

In Figs. 1 and 2, a compact structure of an electronic component is illustrated. The component includes a lead frame 10 as usually employed as support for integrated circuits. On the lead frame 10 a capacitor 14 is mounted by means of a layer 12 of an electrically conductive adhesive. The capacitor 14 is a flat capacitor having a width and length large compared with the overall height thereof. The capacitor 14 has both on its lower face and on its upper face a respective connection contact area 16 and 18 with the aid of which the capacitor 14 can be connected to the respective associated electronic circuit. The lower connection contact area 16 is connected in the example shown by means of the electrically conductive adhesive 12 to the lead frame 10.

By means of a further layer 20 of an electrically conductive adhesive, a semiconductor integrated circuit chip 22 is mounted on the capacitor 14, the electrically conductive adhesive 20 establishing an electrical connection between the lower surface of the semiconductor chip 22 and the upper connection contact area 18 of the capacitor 14. The chip 22 has length and width dimensions not greater than the length and width dimensions of the capacitor 14 so that the perimeter of the chip 22 is accommodated within the perimeter of the capacitor 14.

To a side of the stack comprising the capacitor 14 and the semiconductor chip 22, a further capacitor 24 may be arranged on a conductor of the lead frame 10, said capacitor 24 also being a flat capacitor which like the capacitor 14 is electrically connected with its lower connection contact area 26 via the layer 12 to the lead frame.

With the aid of bond wires 28, 30, 32, connections necessary for a required circuit function can be established between leads of the lead frame 10 or a further conductor 34 of the lead frame 10 separate therefrom as well as between the capacitor 24 and the semiconductor chip 22.

In one embodiment, the semiconductor chip 22 may be an integrated circuit chip embodying the circuit elements of a transponder as described in more detail in European patent application EP-A-0 301 127 and incorporated herein by reference.

The arrangement illustrated in Figs. 1 and 2 can be embedded in a plastic composition to form a housing out of which only a few parts of the lead frame 10, 34 project for establishing outer terminal connections.

The compact accommodation described of a relatively large capacitor together with a semiconductor chip in an electronic component is suitable for all applications where there is only little space for accommodating a relatively large capacitor. As already explained at the beginning, such a use is present in a batteryless responder of a transponder arrangement in which the responder is to be implanted in living animals and for this reason must have very small dimensions. Accordingly, the structure described with reference to Figs. 1 and 2 may be used to implement the circuit arrangement of the transponder described in the above-mentioned European patent application EP-A-0 301 127.

The embodiment of the invention described above may be modified in various ways. For example, two or more integrated circuit chips may be mounted on and in electrically conductive attachment to the upper surface of the flat capacitor so that the chips do not significantly project beyond the perimeter of the capacitor. Alternatively, as shown in Fig. 3 one or more integrated circuit chips 22 could be mounted on and adherently attached to the upper surfaces of side-by-side disposed flat capacitors 14A and 14B mounted on a lead frame and in electrically conductive connection with one or more leads of the lead frame. As illustrated, the integrated circuit chip is adherently attached to the underlying flat capacitors using an electrically insulating adhesive 36 and electrical connections between the chip and the capacitors are effected by bond wires 38.

While rectangular configurations for the capacitor and integrated circuit chip have been exemplified, these are not critical.

## Claims

1. An electronic component comprising a lead frame (10) having a plurality of electrical conductors; a capacitor (14) having an overall height small in comparison with its perimeter length and having opposed surfaces with respective connection areas on the opposed surfaces (16, 18), wherein one of the opposed surfaces (16) of the capacitor (14) mounted on the lead frame (10) is in electrically conductive connection with at least one of said electrical conductors characterized in that at least one semiconductor chip (22) is mounted on and adherently attached to the other of the opposed surfaces (18) of the capacitor (14), thereby forming an electrically conductive connection between said semiconductor chip (22) and said other of the opposed surfaces (18) of the capacitor (14).

2. An electronic component according to claim 1,
characterized in that the or each semiconductor chip (22) is accommodated within the perimeter of the capacitor (14).

3. An electronic component according to claim 1,
characterized in that the semiconductor chip (22) and the capacitor (14) each has a rectangular perimeter and the semiconductor chip (22) does not project beyond the perimeter of the capacitor (14).

4. An electronic component according to claim 1,
characterized in that the semiconductor chip (22) has lengthwise sides oriented in substantially parallel relation with lengthwise sides of the capacitor (14).

5. An electronic component according to claim 1,
characterized in that a connection between the lead frame (10) and the capacitor (14) and a connection between the capacitor (14) and the semiconductor chip (22) is effected by an electrically conductive adhesive (12).

6. An electronic component according to claim 1,
characterized in that it further comprises at least one further flat capacitor (24) mounted on the lead frame (10).

7. An electronic component according to claim 1,
characterized in that said at least one semiconductor chip (22) has opposing surfaces, and one of the opposed surfaces of said at least one semiconductor chip (22) is in electrically conductive connection with said other of the opposed surfaces (18) of said capacitor (14), and in that the other of the opposed surfaces of said at least one semiconductor chip (22) is in electrically conductive connection with said one of the opposed surfaces (16) of said capacitor (14).

8. An electronic component according to claim 7,
characterized in that said electrically conductive connection between the other of the opposed surfaces of at least one semiconductor chip (22) and said one of the opposed surfaces (16) of said capacitor (14) is a bond wire (32).

9. An electronic component comprising a lead frame (10) having a plurality of electrical conductors; a plurality of capacitors (14, 24) each having an overall height small in comparison with its perimeter length and having opposed surfaces with respective connection contact areas on the opposed surfaces (16, 18, 26); characterized in that the capacitors (14, 24) are disposed laterally with respect to each other and each mounted on the lead frame (10) with one of the opposed surfaces (16, 26) in electrically conduction connection with at least one of said electrical conductors; and in that at least one semiconductor chip (22) is mounted on, and adherently attached to the other of the opposed surfaces (18) of at least one of the capacitors (14, 24) thereby forming an electrically conductive connection between said semiconductor chip (22) and the other of the opposed surfaces (18) of at least one of the capacitors (14, 24).

10. An electronic component according to claim 9,
characterized in that the or each semiconductor chip (22) is disposed within a perimeter that is substantially accommodated within a perimeter occupied by the capacitors (14, 24).

## Patentansprüche

1. Elektronisches Bauelement mit einem Leiterrahmen mit mehreren elektrischen Leitern; einem Kondensator (14) mit einer im Vergleich zu seiner Umfangslänge kleinen Gesamthöhe und mit gegenüberliegenden Flächen (16, 18), auf denen sich jeweils Anschlußflächen befinden, wobei eine der gegenüberliegenden Flächen (16) des auf dem Leiterrahmen (10) angebrachten Kondensators (14) in elektrisch leitender Verbindung mit wenigstens einem der elektrischen Leiter steht, dadurch gekennzeichnet, daß auf der anderen der gegenüberliegenden Flächen (18) wenigstens ein Halbleiter-Plättchen (22) angebracht und haftend befestigt ist, wodurch eine elektrisch leitende Verbindung zwischen dem Halbleiter-Plättchen (22) und der anderen der gegenüberliegenden Flächen (18) des Kondensators (14) entsteht.

2. Elektronisches Bauelement nach Anspruch 1, dadurch gekennzeichnet, daß das oder jedes Halbleiter-Plättchen (22) innerhalb des Umfangs des Kondensators (14) angebracht ist.

3. Elektronisches Bauelement nach Anspruch 1, dadurch gekennzeichnet, daß das Halbleiter-Plättchen (22) und der Kondensator (14) jeweils einen rechteckigen Umfang haben und das Halbleiter-Plättchen (22) nicht über den Umfang des Kondensators (14) vorsteht.

4. Elektronisches Bauelement nach Anspruch 1, dadurch gekennzeichnet, daß das Halbleiter-Plättchen (22) Längsseiten aufweist, die im wesentlichen parallel zu den Längsseiten des Kondensators (14) verlaufen.

5. Elektronisches Bauelement nach Anspruch 1, dadurch gekennzeichnet, daß eine Verbindung zwischen dem Leiterrahmen (10) und dem Kondensator (14) sowie eine Verbindung zwischen dem Kondensator (14) und dem Halbleiter-Plättchen (22) mittels eines elektrisch leitenden Klebstoffs (12) hergestellt ist.

6. Elektronisches Bauelement nach Anspruch 1, dadurch gekennzeichnet, daß es außerdem wenigstens einen weiteren Flach-Kondensator (24) enthält, der auf dem Leiterrahmen (10) befestigt ist.

7. Elektronisches Bauelement nach Anspruch 1, dadurch gekennzeichnet, daß das wenigstens eine Halbleiter-Plättchen (22) gegenüberliegende Flächen aufweist und eine der gegenüberliegenden Flächen des wenigstens einen Halbleiter-Plättchens (22) elektrisch mit der anderen der gegenüberliegenden Flächen (18) des Kondensators (14) verbunden ist, und daß die andere der gegenüberliegenden Flächen des wenigstens einen Halbleiter-Plättchens (22) elektrisch mit der einen der entgegengesetzten Flächen (16) des Kondensators (14) verbunden ist.

8. Elektronisches Bauelement nach Anspruch 7, dadurch gekennzeichnet, daß die elektrische Verbindung zwischen der anderen der entgegengesetzten Flächen des wenigstens einen Halbleiter-Plättchens (22) und der einen der entgegengesetzten Flächen (16) des Kondensators (14) ein Bonddraht (32) ist.

9. Elektronisches Bauelement mit einem Leiterrahmen (10) mit mehreren elektrischen Leitern; mehreren Kondensatoren (14, 24) mit einer im Vergleich zu ihren Umfangslängen kleinen Gesamthöhe und mit gegenüberliegenden Flächen (16, 18, 26), auf denen sich jeweils Anschlußkontaktflächen befinden; dadurch gekennzeichnet, daß die Kondensatoren (14, 24) seitlich zueinander und jeweils so auf dem Leiterrahmen (10) angebracht sind, daß eine der entgegengesetzten Flächen (16, 26) in elektrisch leitender Verbindung mit wenigstens einem der elektrischen Leiter stehen; und daß wenigstens ein Halbleiter-Plättchen (22) auf der anderen der entgegengesetzten Flächen (18) des wenigstens einen Kondensators (14, 24) angebracht und haftend befestigt ist, wodurch eine elektrisch leitende Verbindung zwischen dem Halbleiter-Plättchen (22) und der anderen der entgegengesetzten Flächen (18) des wenigstens einen Kondensators (14, 24) entsteht.

10. Elektronisches Bauelement nach Anspruch 9, dadurch gekennzeichnet, daß das oder jedes Halbleiter-Plättchen (22) innerhalb eines Umfangs angeordnet ist, der im wesentlichen innerhalb des von den Kondensatoren (14, 24) eingenommenen Umfangs liegt.

## Revendications

1. Composant électronique comprenant une trame de conducteurs (10) ayant une pluralité de conducteurs électriques ; un condensateur (14) ayant une hauteur totale petite en comparaison avec sa longueur de périmètre et ayant des surfaces opposées avec des zones de connexion respectives sur les surfaces opposées (16, 18), dans lequel l'une des surfaces opposées (16) du condensateur (14) monté sur la trame de conducteurs (10) est en connexion conductrice électriquement avec au moins l'un des conducteurs électriques, caractérisé en ce qu'au moins une pastille semi-conductrice (22) est montée et fixée de manière adhérente sur l'autre des surfaces opposées (18) du condensateur (14), pour former ainsi une connexion conductrice électriquement entre ladite pastille semi-conductrice (22) et ladite autre des surfaces opposées (18) du condensateur (14).

2. Composant électronique selon la revendication 1, caractérisé en ce que la ou chaque pastille semi-conductrice (22) est reçue dans le périmètre du condensateur (14).

3. Composant électronique selon la revendication 1, caractérisé en ce que la pastille semi-conductrice (22) et le condensateur (14) ont chacun un périmètre rectangulaire et en ce que la pastille semi-conductrice (22) ne s'étend pas au-delà du périmètre du condensateur (14).

4. Composant électronique selon la revendication 1, caractérisé en ce que la pastille semi-conductrice (22) a des côtés suivant sa longueur orientés selon une relation substantiellement parallèle avec des cotés suivant la longueur du condensateur (14).

5. Composant électronique selon la revendication 1, caractérisé en ce qu'une connexion entre la trame de conducteurs (10) et le condensateur (14) et une connexion entre le condensateur (14) et la pastille semi-conductrice (22) sont réalisées par un adhésif conducteur électriquement (12).

6. Composant électronique selon la revendication 1, caractérisé en ce qu'il comporte en outre au moins un autre condensateur plat (24) monté sur la trame de conducteurs (10).

7. Composant électronique selon la revendication 1, caractérisé en ce que ladite au moins une pastille semi-conductrice (22) a des surfaces opposées et l'une des surfaces opposées de ladite au moins une pastille semi-conductrice (22) est en connexion conductrice électriquement avec ladite autre des surfaces opposées (18) dudit condensateur (14) et en ce que l'autre desdites surfaces opposées de ladite au moins une pastille semi-conductrice (22) est en connexion conductrice électriquement avec ladite une surface opposée (16) dudit condensateur (14).

8. Composant électronique selon la revendication 7, caractérisé en ce que ladite connexion conductrice électriquement entre l'autre des surfaces opposées de ladite une pastille semi-conductrice (22) et ladite une surface opposée (16) dudit condensateur (14) est un fil de liaison (32).

9. Composant électronique comprenant une trame de conducteurs (10) ayant une pluralité de conducteurs électriques ; une pluralité de condensateurs (14, 24) ayant chacun une hauteur totale petite en comparaison avec sa longueur de périmètre et ayant des surfaces opposées avec des zones de contact de connexion respectives sur les surfaces opposées (16, 18, 26) ; caractérisé en ce que les condensateurs (14, 24) sont disposés latéralement les uns par rapport aux autres et sont montés chacun sur la trame de conducteurs (10) avec l'une des surfaces opposées (16, 26) en connexion de conduction électrique avec au moins l'un desdits conducteurs électriques ; et en ce qu'au moins une pastille semi-conductrice (22) est montée et fixée de manière adhérente sur l'autre des surfaces opposées (18) d'au moins l'un des condensateurs (14, 24) formant ainsi une connexion conductrice électriquement entre ladite pastille semi-conductrice (22) et l'autre des surfaces opposées (18) d'au moins l'un des condensateurs (14, 24).

10. Composant électronique selon la revendication 9, caractérisé en ce que la ou chaque pastille semi-conductrice (22) est disposée dans un périmètre qui est reçu substantiellement dans un périmètre occupé par les condensateurs (14, 24).
